Europäisches Patentamt

European Patent Office

Office européen des brevets

(11) Publication number: **0 179 056**
**B1**

(12) **EUROPEAN PATENT SPECIFICATION**

(45) Date of publication of patent specification: **22.08.90**

(21) Application number: **84901896.5**

(22) Date of filing: **20.04.84**

(86) International application number:
**PCT/US84/00616**

(87) International publication number:
**WO 85/04995 07.11.85 Gazette 85/24**

(51) Int. Cl.⁵: **H 03 M 1/20, H 04 B 1/06**

(54) **EXTENDED THRESHOLD ANALOG TO DIGITAL CONVERSION APPARATUS FOR AN RF RECEIVER.**

(43) Date of publication of application:
**30.04.86 Bulletin 86/18**

(45) Publication of the grant of the patent:
**22.08.90 Bulletin 90/34**

(84) Designated Contracting States:
**AT BE CH DE FR GB LI LU NL SE**

(56) References cited:
**FR-A-2 308 257**
**GB-A-0 873 926**
**GB-A-1 580 178**
**US-A-3 877 022**
**US-A-3 879 724**

(73) Proprietor: **MOTOROLA, INC.**
**1303 East Algonquin Road**
**Schaumburg, IL 60196 (US)**

(72) Inventor: **JANC, Robert, Vincent**
**6650 West 131 Street**
**Palos Heights, IL 60463 (US)**

(74) Representative: **Ibbotson, Harold et al**
**MOTOROLA European Intellectual Property**
**Operations Jays Close Viables Ind. Estate**
**Basingstoke Hants RG22 4PD (GB)**

Courier Press, Leamington Spa, England.

## Description

### Background of the Invention

This invention relates generally to communications receivers having analog to digital (A/D) conversion by an A/D converter of analog signals having a magnitude less than the threshold sensitivity of the A/D converter. Threshold sensitivity refers to the lowest magnitude analog signal which will cause the A/D converter to change the digital state of its output. This invention is specifically, but not exclusively, adapted to convert low level radio frequency (RF) analog signals received by a communications receiver into digital signals wherein such digital signals are processed using digital rather than conventional analog techniques.

In a conventional wireless receiver, the low level received signal is processed with analog circuits including conversion to an intermediate frequency, amplification, filtering, and then demodulated to extract the information carried by the signal. With the advancements in digital technology, especially in digital filters and in digital signal processors, many, if not all of the functions of a receiver can be implemented digitally. However, before any digital processing can occur, the normally low level analog signal presented to the receiver must be converted into digital form.

The initial A/D conversion of the received signal presents several problems. In a land mobile system the magnitude of a received signal may be as low as 0.5 microvolts (uV). This signal level is significantly lower than the threshold sensitivity available in a conventional A/D converter; for example, a commercially available 1 volt 14 bit A/D converter has a threshold wherein the least significant bit (LSB) in its output corresponds to an analog input voltage of 61 uV. A substantial range (0.5uV—60uV) of input signal levels which is useful in conventional analog receivers, would not be detected by such an A/D converter and could not be processed by digital signal processing.

Of course, an amplifier could be utilized to amplify low level received signals prior to the A/D conversion.

However, such an amplifier would likely give rise to severe intermodulation distortion in a land mobile receiver and would itself provide an intermodulation limit. If a stronger signal is present concurrently with a low level desired signal, the A/D quantizing noise will have a narrow frequency spectrum and can result in severe intermodulation distortion. By converting a received RF analog signal into digital form, the A/D converter functions as a quantizer, that is, it functions to subdivide the analog signal into small but measurable increments.

The mathematical relationship between distortion and quantization step size is addressed in an article by W. R. Bennett entitled "Spectra of Quantized Signals" published in the *Bell System Technical Journal*, July 1948, pages 446—472.

In an article by Leonard Schuchman entitled "Dither Signals and Their Effect on Quantization Noise" published in the *IEEE Transactions on Communication Technology* December 1964, pages 162-165, the mathematical relationship between a dither signal and quantization noise is addressed.

Arthur Stephenson's article "Digitizing Multiple RF Signals Requires an Optimum Sampling Rate" published in *Electronics*, March 27, 1972 pages 106—110, discloses a concept for utilizing an A/D converter, digital filter and digital demodulator for receiving and processing RF signals. The disclosed concept envisioned utilizing an automatic gain controlled amplifier to amplify the low level filtered RF signal prior to the A/D conversion.

In U.S. Patent No. 3,816,831 to Leonard Mollod, the disclosed invention relates to the processing of Loran signals using hard-limiting techniques. RF noise is added to the input signal to maintain a desired signal to noise ratio. The combined signal and noise is amplified by a hard-limiting amplifier prior to the information decoding.

A digital integrating and auto-correlator apparatus is disclosed in U.S. Patent No. 4,288,857 to Jack Wilterding and John Cozzens and is directed generally to signal-to-noise ratio enhancement. A signal containing noise and a separate reference noise signal are alternately coupled through an analog switch, a low pass filter, and a sample and hold circuit to an A/D converter.

It is known from U.S. 3,877,022 to enhance the resolution in analog to digital conversion by adding statistically controlled noise to the analog input signal. However this-reference requires oversampling of the input signal which can be difficult or impossible at radio frequencies.

### Summary of the Invention

It is therefore an object of this invention to minimize the above mentioned problems relating to the conversion of low level RF signals into digital form in a communication receiver.

According to the present invention, there is provided a communications receiver having a band pass filter with a bandwidth which permits the passage of an analog radio frequency (RF) input signal having a frequency within a predetermined range of frequencies and an analog to digital (A/D) converter having a digital data output, comprising:

means for generating a noise signal which does not have any substantial energy within said range of frequencies;

means for summing said filtered analog RF input signal and said noise signal to produce a resultant signal that is coupled to an input of the A/D converter;

clock means for generating periodic pulses at a first frequency coupled to the A/D converter causing the latter to make A/D conversions in response thereto, said first frequency being less than the lowest frequency of said RF input signal within said range;

said summing means producing a resultant signal containing a signal component corresponding to said analog RF input signal which is converted by the A/D converter into a digital data representation.

Accordingly, the present invention, as defined, provides for a communications receiver utilizing digital processing, in which a low level received RF signal is filtered by means of a band pass filter or preselector and received by a sample and hold circuit. The output of the sample and hold circuit is summed with a noise source and received by an A/D converter which provides a digital output to a digital signal processor for digital filtering and demodulation. A clock is utilized to drive the sample and hold circuit, A/D converter, and digital signal processor. The noise source is bandwidth restricted so that the noise energy does not occupy the same frequency range as the incoming desired signals.

Brief Description of the Drawings

Figure 1 is a block diagram illustrating an embodiment of the present invention.

Figure 2 is a schematic diagram illustrating a sample and hold circuit suitable for use in the embodiment shown in figure 1.

Figure 3 is a block diagram of an embodiment of the present invention in a communications receiver.

Detailed Description

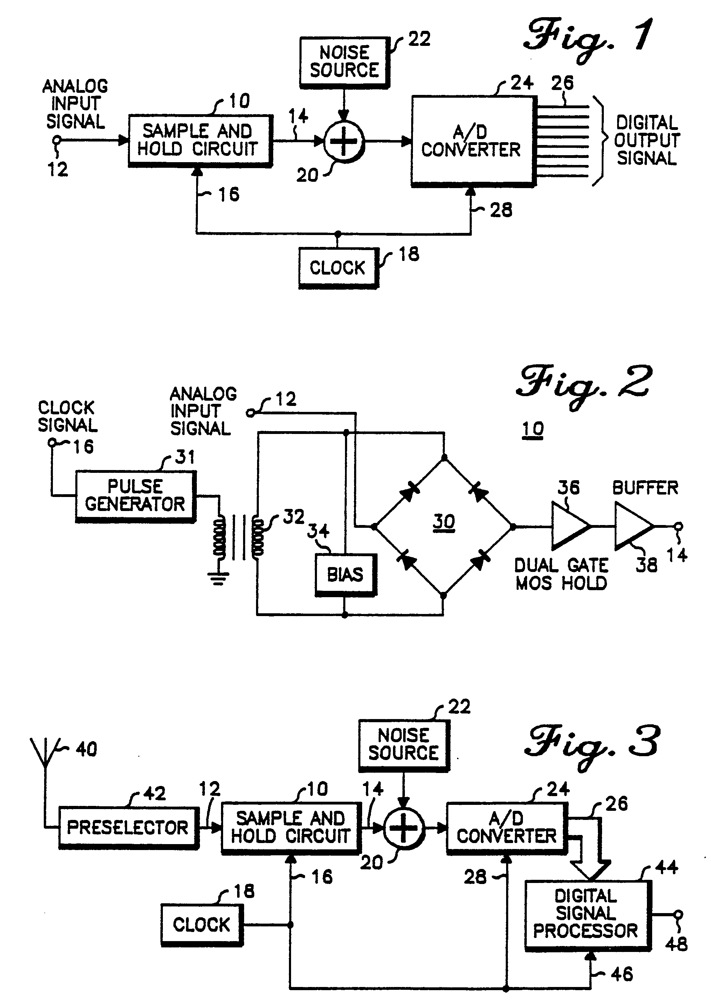

In the embodiment of this invention shown in figure 1, a sample and hold circuit 10 includes an input port 12 for accepting an analog input signal, an output 14, and a gating control input 16. The purpose of sample and hold circuit 10 is to monitor the varying instantaneous voltage presented by the analog alternating current (AC) input signal and store an instantaneous voltage level of the analog input signal. Output pulses of clock 18 are received by input 16 and determine the instants in time when the analog input signal waveform is sampled. The sample and hold circuit 10 stores the magnitude of the sampled signal until the next sample interval. The output 14 of circuit 10 may consist of the stored voltage level or a signal proportional to the sampled voltage level.

A summation circuit 20 sums the signal from output 14 of the sample and hold circuit 10 together with the output from a noise source 22. The output of noise source 22 preferably consists of a moderately wide band noise signal such as a bandwidth of 50 KHz or greater. The bandwidth of the noise signal should be selected so that it does not overlap or occupy part of the range of frequencies in which desired analog input signals occur. For example, low pass or bandpass filtered Gaussian noise can be used.

An analog to digital converter 24 receives the resulting composite signal, which contains a signal component corresponding to the analog input signal, from summation circuit 20 and converts it into a digital output signal (data) defined by the binary state of digital outputs 26. The output from clock 18 is received at input 28 of converter 24 which utilizes the clock pulses for gating purposes to control the time when analog to digital conversions are to occur.

The amplitude of the noise signal supplied by noise source 22 should be less than the peak to peak voltage range of the A/D converter 24, i.e. the noise signal should not cause the A/D converter to clip. For example, a noise signal approximately 15 decibels (dB) below the maximum peak to peak voltage range of the A/D converter is suitable.

Summing a noise signal having a predetermined bandwidth and magnitude level selected relative to the range of the A/D converter permits analog input signals having a magnitude less than threshold sensitivity of the A/D converter to be detected by the converter. The noise signal also has an additional benefit of "whiting" the spectrum of the A/D converter's quantizing noise; that is, the quantizing noise at the output of the A/D converter will have an essentially uniform power spectral density. The sampling or clock rate should be high enough so that the spectral power of the quantizing noise in the received analog input signal bandwidth is low; that is, the ratio of the sample rate to the bandwidth of the desired signal should be large, preferably 10 or greater. The improvement in threshold sensitivity achieved by this invention increases as this ratio increases.

Although noise source 22 is shown being summed with the output of sample and hold circuit 10 by means of summation circuit 20, a noise source could be combined with the desired analog input signal preceding the sample and hold circuit 10 as opposed to after it. That is, the analog input signal could be summed with a noise source and the resulting summed signal applied to a sample and hold circuit having its output coupled directly to the A/D converter.

The use of a sample and hold circuit 10 presumes that the rate of change or frequency of the analog input signal is too great or high for the A/D converter 24 to process. If the rate of change or frequency of the analog input signal is within the capability of the A/D converter, then a sample and hold circuit need not be used. In such an application, the analog input signal would be applied directly to the summation circuit 20 in the place of the output 14 of the sample and hold circuit as shown in figure 1.

In an exemplary embodiment of the present invention according to figure 1, a commercially available 1 volt (± 0.5 volt) 8 bit A/D converter having 256 steps was utilized. An applied analog RF input signal at 900.455 Megahertz (MHz) having a 10 Kilohertz (KHz) bandwidth was sampled at a clock rate of 20 MHz. A low pass filtered Gaussian noise source having a bandwidth of 0—50 KHz generated a noise signal with a total power 9dB below the root mean square (rms) value of the peak to peak voltage range of the A/D converter. This converter has a threshold sensitivity or step size of 3.9 millivolts (mV). Without utilizing the present invention, the A/D converter would be unable to recognize the presence of an analog signal which did not exceed 3.9 mV. However, utilizing this invention, an analog input signal having a magnitude of only 0.2 mV was detected and converted into a digital output signal by the A/D converter. Thus, from this particular example of the present invention, it will be apparent that analog input signals having an amplitude significantly lower than the threshold sensitivity of the A/D converter can be achieved.

With respect to the low pass filtered Gaussian noise referenced in the above example, its bandwidth should be increased as the sampling rate increases and could be decreased if an A/D converter having a greater number of bits was utilized. Other types of noise sources which meet the following criteria can also be used: 1) no substantial energy at the frequency of the desired signal; 2) causes the quantization noise at the output of the A/D converter to have an essentially uniform power spectral density; 3) magnitude of the noise signal does not cause the A/D converter to clip. For example, a plurality of sine waves or a numerically (computer) generated noise signal could be employed.

In figure 2, a particular sample and hold circuit 10 is illustrated. The analog input signal is coupled at input 12 to a diode sampling bridge 30. The clock signal from clock 18 is coupled at input 16 to a pulse generator 31 having its output pulse coupled by means of transformer 32 to sampling bridge 30 as shown. The width (time duration) of the output pulse from the pulse generator should be less than one-half of the reciprocal of the frequency of the analog input signal. Operating bias for bridge 30 is supplied by a conventional bias circuit 34.

The clock signals as coupled to bridge 30 cause the bridge to alternately be conductive and nonconductive. Thus, bridge 30 acts as a gate which alternately couples and inhibits the coupling of the analog input signal to the input of a dual gate MOS hold integrated circuit 36. When the bridge is conducting, the analog input signal will be coupled to hold IC 36; when the bridge is not conducting, analog input signal will be blocked and not coupled to hold IC 36. The output of the hold IC 36 is coupled to a buffer 38 which has an output 14.

Figure 3 illustrates another embodiment of the present invention utilized in a "front end" of a communications receiver. The front end refers to the initial signal processing section in a receiver. A received RF signal is sensed by antenna 40 which couples it to a preselector 42 which preferably consists of a band pass filter designed to pass the range of frequencies in which desired received signals may occur. The filtered signal is coupled from preselector 42 to the input 12 of sample and hold circuit 10. The operation of sample and hold circuit 10, clock 18, noise source 22, summation ciruit 20, and A/D converter 24 in figure 3 is the same as previously explained with respect to figure 1 and therefore is not repeated.

The digital outputs 26 of A/D converter 24 can be coupled to a digital signal processor 44 for filtering and digital information recovery. Various types of digital filtering and digital signal processing are well known in the art and various digital signal processors are commercially available. The output of clock 18 may also provide a clock reference to an input 46 of the digital signal processor. The output 48 of the processor may comprise the desired information carried by the received signal. For example, the desired information may consist of voice communication (speech) or data.

The particular implementation of a digital signal processor 44 or other alternative processing techniques do not comprise part of the present invention and hence will not be described in detail.

The elements in figure 3 which are common to figure 1 provide the same advantage in a receiver, that is, the magnitude of the analog received signal which can be detected and converted into digital form by A/D converter 24 is substantially lower than the threshold sensitivity of the A/D converter itself. Thus, the present invention provides an improved sensitivity for the receiver. To meet a given receiver sensitivity, the present invention allows a receiver to utilize no amplification (or less amplification depending upon the particular specification) of a received signal prior to the A/D conversion. Even if an amplifier is required, the gain of the amplifier for the same receiver sensitivity level can be considerably less by the use of the present invention. Minimizing the gain required for such an amplifier or eliminating the need for the amplifier will improve the intermodulation distortion characteristic of the receiver. Also the injection of a limited bandwidth noise signal from noise source 22 tends to broaden the spectral content of the quantizing noise of the A/D converter itself and thus improves the intermodulation chracteristic of the A/D converter.

## Claims

1. A communications receiver having a band pass filter (42) with a bandwidth which permits the passage of an analog radio frequency (RF) input signal having a frequency within a predetermined range of frequencies and an analog to digital (A/D) converter (24) having a digital data output (26), characterized by:

means (22) for generating a noise signal which does not have any substantial energy within said range of frequencies;

means (20) for summing said filtered analog RF input signal and said noise signal to produce a resultant signal that is coupled to an input of the A/D converter (24);

clock means (18) for generating periodic pulses at a first frequency coupled to the A/D converter causing the latter to make A/D conversions in response thereto, said first frequency being less than the lowest frequency of said RF input signal within said range;

said summing means producing a resultant signal containing a signal component corresponding to said analog RF input signal which is converted by the A/D converter (24) into a digital data representation (26).

2. The communications receiver according to claim 1 wherein said generating means (22) generates a noise signal that produces quantization noise at the digital data output from the A/D converter (24) having an essentially uniform power spectral density.

3. The communications receiver according to claim 1 wherein said generating means (22) generates a Gaussian noise signal.

4. The communications receiver according to claim 1 wherein said generating means (22) generates a noise signal having an amplitude less than the maximum voltage range of the A/D converter.

5. The communications receiver according to claim 4 wherein the amplitude of the noise signal is approximately 15 decibels less than the maximum voltage range of the A/D converter.

6. The communications receiver according to claim 1 wherein the ratio of the rate of said periodic pulses to the bandwidth of said analog AC input signal is greater than 10.

7. The communications receiver apparatus according to claim 1 further comprising means (10) for periodically sampling the amplitude of the filtered analog RF input signal and storing the sampled amplitude, said stored amplitude coupled to said summing means and summed with said noise signal to produce said resultant signal.

8. The communications receiver according to claim 7 wherein said sampling means (10) includes means for generating sampling pulses which determine the duration of the sampling pulses, the time duration of the sampling pulses being less than 0.5 times the reciprocal of the frequency of said analog RF input signal.

9. The communications receiver according to claim 1 wherein said A/D converter (24) has a given threshold sensitivity and the magnitude of said AC input signal is less than said threshold sensitivity, said signal component corresponding to the AC input signal being converted by the A/D into digital data, whereby AC input signals having a magnitude less than said given threshold sensitivity of the A/D converter can be converted into digital data thereby extending the threshold sensitivity of the A/D converter.

10. A method for converting an analog radio frequency (RF) signal having a given frequency into digital data, comprising the steps of:

band pass filtering said analog RF signal;
storing a first signal corresponding to an instantaneous magnitude of said filtered analog RF signal;
generating a noise signal which does not have any substantial energy at said given frequency;

summing said first signal and said noise signal to produce a resultant signal;

coupling said resultant signal to an analog to digital (A/D) converter (24); and

generating periodic clock pulses at a first frequency which are coupled to said A/D converter and cause A/D conversions to be made in response to said pulses, said first frequency being less than the lowest frequency of said RF signal within said range.

11. The method according to claim 10 further comprising the step of periodically sampling the instantaneous magnitude of said analog RF signal and storing a first signal corresponding to said sampled magnitude.

12. The method according to claim 10 wherein the ratio of the rate of the clock pulses to the bandwidth of the analog RF signal is greater than 10.

13. The method according to claim 11 wherein said sampling step includes the step of generating sampling pulses that determine the duration of the sampling pulses, the sampling pulses being less than 0.5 times the reciprocal of the frequency of said analog RF signal.

14. The method according to claim 10 wherein said A/D converter has a given threshold sensitivity and the magnitude of said RF signal is less than said threshold sensitivity, wherein the converting by the A/D converter of the signal component into digital data effectively extends the threshold sensitivity of the A/D converter.

**Patentansprüche**

1. Nachrichten-Empfänger mit einem Bandpaßfilter (42), dessen Bandbreite für ein analoges Funkfrequenz-Eingangssignal (RF) durchlässig ist, dessen Frequenz innerhalb eines vorgegebenen Frequenzbereiches liegt, und mit einem Analog/Digitalwandler (24), der digitale Daten (26) ausgibt, gekennzeichnet

durch ein Hilfsmittel (22) zur Erzeugung eines Störsignals, das innerhalb des Frequenzbereiches keine wesentliche Energie aufweist,

durch ein Hilfsmittel (20) zum Aufsummieren des gefilterten analogen Funkfrequenz-Eingangssignals und des Störsignals, so daß ein Ergebnissignal entsteht, das an einen Eingang des Analog/Digitalwandlers (24) angelegt wird, und

durch einen Taktgeber (18) zur Erzeugung periodischer pulse bei einer ersten Frequenz, die an den Analog/Digitalwandler angelegt werden, wodurch der letztere in Abhängigkeit von den Pulsen zu Analog/Digitalwandlungen veranlaßt wird, wobei die erste Frequenz geringer als die niedrigste Frequenz des Funkfrequenz-Eingangssignals innerhalb des Bereiches ist, und wobei das aufsummierende Hilfsmittel ein Ergebnissignal hervorbringt, das eine Signalkomponente enthält, die dem analogen Funkfrequenz-Eingangssignal entspricht, das von dem Analog/Digitalwandler (24) in eine digitale Datenwiedergabe (26) gewandelt wird.

2. Nachrichten-Empfänger gemäß Anspruch 1, bei dem das erzeugende Hilfsmittel (22) ein Störsignal erzeugt, das unter den digitalen Datenausgangssignalen des Analog/Digitalwandlers (24) ein quantisiertes Rauschen hervorbringt, das eine im wesentlichen gleichförmige spektrale Leistungsdichte besitzt.

3. Nachrichten-Empfänger gemäß Anspruch 1, bei dem das erzeugende Hilfsmittel (22) ein Gaußsches Störsignal hervorbringt.

4. Nachrichten-Empfänger gemäß Anspruch 1, bei dem das erzeugende Hilfsmittel (22) ein Störsignal mit einer Amplitude hervorbringt, die geringer als der maximale Spannungsbereich des Analog/Digitalwandlers ist.

5. Nachrichten-Empfänger gemäß Anspruch 4, bei dem die Amplitude des Störsignals annähernd 15 db geringer als der maximale Spannungsbereich des Analog/Digitalwandlers ist.

6. Nachrichten-Empfänger gemäß Anspruch 1, bei dem das Verhältnis der Folge periodischer Pulse zu der Bandbreite des analogen Wechselstrom-Eingangssignals größer als 10 ist.

7. Nachrichten-Empfänger gemäß Anspruch 1, bei dem ein Hilfsmittel (10) zum periodischen Abgreifen und Prüfen der Amplitude des gefilterten, analogen Eingangssignals und zum Speichern der abgegriffenen Amplitude vorgesehen ist und die gespeicherte Amplitude, an das aufsummierende Hilfsmittel angelegt, mit dem Störsignal zur Erzeugung des Ergebnissignals summiert wird.

8. Nachrichten-Empfänger gemäß Anspruch 7, bei dem das Hilfsmittel (10) zum Abgreifen und Prüfen einen Erzeuger von Prüfimpulsen enthält, das die Dauer der Prüfimpulse derart festlegt, daß sie geringer als das 0,5 fache der reziproken Frequenz des analogen Funkfrequenz-Eingangssignals ist.

9. Nachrichten-Empfänger gemäß Anspruch 1, bei dem der Analog/Digitalwandler (24) eine gegebene Schwellenwert-Empfindlichkeit besitzt und die Größe des Wechselstrom-Eingangssignals niedriger als die Schwellenwert-Empfindlichkeit ist, wobei die Signalkomponente, die dem Wechselstrom-Eingangssignal entspricht, durch die Analog/Digitalwandlung umgewandelt wird und die Wechselstrom-Eingangssignale von geringerer Größe als die gegebene Schwellenwert-Empfindlichkeit des Analog/Digitalwandlers in digitale Daten umgewandelt werden können, wodurch die Schwellenwert-Empfindlichkeit des Analog/Digitalwandlers ausgedehnt wird.

10. Verfahren zur Umwandlung eines analogen Funkfrequenzsignals von gegebener Frequenz in digitale Daten mit den Arbeitsschritten:

daß ein Bandpaß das analoge Funkfrequenzsignal filtert,

daß entsprechend einer Augenblicksgröße des gefilterten, analogen Funkfrequenzsignals ein erstes Signal gespeichert wird.

daß ein Störsignal erzeugt wird, das bei der gegebenen Frequenz keine wesentliche Energie besitzt,

daß zur Erzeugung eines Ergebnissignals das erste Signal und das Störsignal aufsummiert werden,

daß das Ergebnissignal an einen Analog/Digitalwandler (24) angelegt wird, und

daß bei einer ersten Frequenz periodische Taktpulse erzeugt und dem Analog/Digitalwandler zugeführt werden, um die Analog/Digitalumwandlungen in Abhängigkeit von den Pulsen zu bewirken, wobei die erste Frequenz niedriger als die niedrigste Frequenz des Funkfrequenzsignals innerhalb des Bereiches ist.

11. Verfahren gemäß Anspruch 10, bei dem ferner die Augenblicksgröße des analogen Funkfrequenzsignals periodisch abgegriffen und geprüft und entsprechend der abgegriffenen und geprüften Größe ein erstes Signal gespeichert wird.

12. Verfahren gemäß Anspruch 10, bei dem das Verhältnis der Folge der Taktpulse zu der Bandbreite des analogen Funkfrequenzsignals größer als 10 ist.

13. Verfahren gemäß Anspruch 11, bei dem zum Abgreifen und prüfen eine Erzeugung von Prüfpulsen gehört, durch die ihre Dauer mit weniger als dem 0,5 fachen der reziproken Frequenz des analogen Funkfrequenzsignals festgelegt wird.

14. Verfahren gemäß Anspruch 10, bei dem der Analog/Digitalwandler eine gegebene Schwellenwert-Empfindlichkeit aufweist und die Größe des Funkfrequenzsignals geringer als die Schwellenwert-Empfindlichkeit ist, und bei dem durch die Umwandlung der Signalkomponente im Analog/Digitalwandler in digitale Daten effektiv die Schwellenwert-Empfindlichkeit des Analog/Digitalwandlers ausgedehnt wird.

**Revendications**

1. Récepteur de communication comportant un filtre passe-bande (42) avec une bande passante qui permet le passage d'un signal analogique en radiofréquence (RF) d'entrée ayant une fréquence comprise dans une gamme de fréquences prédéterminée et un convertisseur analogiquenumérique (A/N) (24) comportant une sortie de données numériques (26), caractérisé par:

un moyen (22) pour engendrer un signal de bruit qui n'a pas d'énergie substantielle dans la gamme de fréquences;

un moyen (20) pour faire la somme du signal analogique RF filtré d'entrée et du signal de bruit afin de produire un signal résultant qui est envoyé à une entrée du convertisseur A/N (24);

un moyen à horloge (18) pour engendrer des impulsions périodiques à une première fréquence envoyées au convertisseur A/N faisant en sorte que ce dernier exécute des conversions A/N en réponse à celles-ci, la première fréquence étant inférieure à la fréquence la plus basse du signal RF d'entrée dans ladite gamme;

le moyen sommateur produisant un signal résultant qui contient une composante de signal correspondant au signal analogique RF d'entrée convertie par le convertisseur A/N (24) en une représentation de données numériques (26).

2. Récepteur de communication selon la revendication 1, dans lequel le moyen générateur (22) engendre un signal de bruit qui produit un bruit de quantification à la sortie de données numériques du convertisseur A/N (24) ayant une densité spectrale de puissance essentiellement uniforme.

3. Récepteur de communication selon la revendication 1, dans lequel le moyen générateur (22) engendre un signal de bruit gaussien.

4. Récepteur de communication selon la revendication 1, dans lequel le moyen générateur (22) engendre un signal de bruit ayant une amplitude inférieure à la marge maximale de tension du convertisseur A/N.

5. Récepteur de communisation selon la revendication 4, dans lequel l'amplitude du signal de bruit est approximativement inférieure de 15 décibels à la marge maximale de tension du convertisseur A/N.

6. Récepteur de communication selon la revendication 1, dans lequel le rapport de la fréquence des impulsions périodiques à la largeur de bande du signal analogique en courant alternatif d'entrée est supérieur à 10.

7. Appareil récepteur de communication selon la revendication 1, comprenant en outre un moyen (10) pour échantillonner périodiquement l'amplitude du signal analogique RF filtré d'entrée et pour mémoriser l'amplitude échantillonnée, l'amplitude mémorisée étant envoyée au moyen sommateur et sommée avec le signal de bruit pour produire le signal résultant.

8. Récepteur de communication selon la revendication 7, dans lequel le moyen d'échantillonnage (10) comprend un moyen pour engendrer des impulsions d'échantillonnage qui déterminent la durée des impulsions d'échantillonnage, la durée des impulsions d'échantillonnage étant inférieure à 0,5 fois l'inverse de la fréquence du signal analogique RF d'entrée.

9. Récepteur de communication selon la revendication 1, dans lequel le convertisseur A/N (24) a un seuil de sensibilité donné et l'amplitude du signal en courant alternatif d'entrée est inférieure au seuil de sensibilité, la composante de signal correspondant au signal d'entrée en courant alternatif étant convertie par le convertisseur A/N en données numériques, les signaux en courant alternatif d'entrée ayant de la sorte une amplitude inférieure au seuil de sensibilité donné du convertisseur A/N qui peut être convertie en données numériques, ce qui étend le seuil de sensibilité du convertisseur A/N.

10. Procédé pour convertir un signal analogique en radiofréquence (RF) ayant une fréquence donnée en données numériques, comprenant les opérations consistant à:

filtrer le signal analogique RF par filtre passe-bas;

mémoriser un premier signal correspondant à une amplitude instantanée du signal analogique RF filtré;

engendrer un signal de bruit qui n'a pas une énergie substantielle à la fréquence donnée;

sommer le premier signal et le signal de bruit pour produire un signal résultant;

envoyer le signal résultant à un convertisseur analogique-numérique (A/N) (24); et à

engendrer des impulsions d'horloge périodiques à une première fréquence qui sont envoyées au convertisseur A/N et font en sorte que les conversions A/N sont exécutées en réponse à ces impulsions, la première fréquence étant inférieure à la plus basse fréquence du signal RF dans la gamme.

11. Procédé selon la revendication 10, comprenant en outre l'opération consistant à échantillonner périodiquement l'amplitude instantanée du signal analogique RF et à mémoriser un premier signal correspondant à l'amplitude échantillonnée.

12. Procédé selon la revendication 10, dans lequel le rapport de la fréquence des impulsions d'horloge à la largeur de bande du signal analogique RF est supérieur à 10.

13. Procédé selon la revendication 11, dans lequel l'opération d'échantillonnage comprend l'opération consistant à engendrer des impulsions d'échantillonnage qui déterminent la durée des impulsions d'échantillonnage, les impulsions d'échantillonnage étant inférieures à 0,5 fois l'inverse de la fréquence du signal analogique RF.

14. Procédé selon la revendication 10, dans lequel le convertisseur A/N a un seuil de sensibilité donné et l'amplitude du signal RF est inférieure au seuil de sensibilité, dans lequel la conversion exécutée par le convertisseur A/N de la composante de signal en données numériques étend effectivement le seuil de sensibilité du convertisseur A/N.

EP 0 179 056 B1

*Fig. 1*

NOISE SOURCE — 22

ANALOG INPUT SIGNAL

SAMPLE AND HOLD CIRCUIT — 10

A/D CONVERTER — 24 — 26

DIGITAL OUTPUT SIGNAL

12 / 14 / 20 / 16 / 28

CLOCK — 18

*Fig. 2*

CLOCK SIGNAL — 16

ANALOG INPUT SIGNAL — 12

PULSE GENERATOR — 31

10

32 / 34

BIAS

30

36

BUFFER

DUAL GATE MOS HOLD

38 / 14

*Fig. 3*

NOISE SOURCE — 22

40

PRESELECTOR — 42

12

SAMPLE AND HOLD CIRCUIT — 10

14

A/D CONVERTER — 24 — 26

20

28

DIGITAL SIGNAL PROCESSOR — 44

48

46

CLOCK — 18

16

1